# EUROPEAN PATENT APPLICATION

(11) **EP 1 715 584 A1**
(43) Date of publication of application: **25.10.2006**
(21) Application number: 05799099.6
(22) Date of filing: 27.10.2005
(51) Int. Cl.: H03K 19/0185

(54) **LEVEL SHIFT CIRCUIT AND SEMICONDUCTOR INTEGRATED CIRCUIT HAVING THE SAME**

(30) Priority: 17.02.2005 JP 2005041291
(71) Applicant: MATSUSHITA ELECTRIC INDUSTRIAL CO., LTD., Osaka 571-8501 (JP)
(72) Inventor: MATSUSHITA, Tsuyoshi, Shiromi, Chuo-ku, Osaka-shi (JP)
(74) Representative: Grünecker, Kinkeldey, Stockmair & Schwanhäusser Anwaltssozietät
(86) International application number: PCT/JP2005/019780
(87) International publication number: WO 2006/087845

(57) **Abstract**

In a level shift circuit, including two Nch transistors Tn1, Tn2 receiving a pair of complementary input signals and two Pch Transistors Tp1, Tp2 of which gate terminals are cross-coupled to each other, nodes A and B as the drains of the two Nch transistors Tn1, Tn2 operating in reverse to each other are connected together with a resistance Tp3. The resistance Tp3, constructed of a Pch transistor, is grounded at its gate to be in the normally ON state. For example, when the Nch transistors Tn1 and Tn2 go ON and OFF, respectively, a current initially flows from the high-potential node A through the resistance Tp3 to the low-potential node B, raising the potential at the low-potential node B. Thus, the potential rise at the node B is sped up compared with the case that only the Pch transistor Tp2 becoming ON contributes to the potential rise. This enables high-speed operation of the level shift circuit with a small number of elements.

## Description

### TECHNICAL FIELD

The present invention relates to a level shift circuit required for a semiconductor integrated circuit having different power-supply voltages.

### BACKGROUND ART

A conventional level shift circuit will be described.

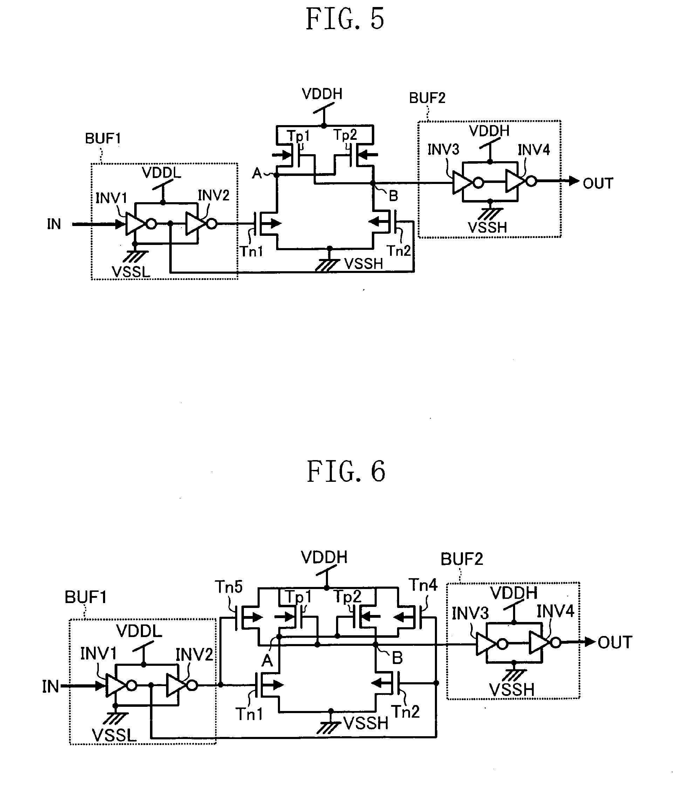

FIG. **5** shows a conventional level shift circuit. Referring to FIG. **5, BUF1** denotes a buffer including inverters **INV1, INV2** operating at a low power-supply voltage, **BUF2** denotes a buffer including inverters **INV3, INV4** operating at a high power-supply voltage, **VDDH** and **VDDL** respectively denote a high-voltage power supply and a low-voltage power supply, **VSSH** and **VSSL** respectively denote grounds (0V) for the high-voltage and low-voltage power supplies, **Tn1** and **Tn2** respectively denote first and second N-channel (Nch) MOS transistors, **Tp1** and **Tp2** respectively denote first and second P-channel (Pch) MOS transistors, **IN** denotes an input signal terminal, **OUT** denotes an output signal terminal, A denotes a node to which the drain of the Nch MOS transistor **Tn1,** the drain of the Pch MOS transistor **Tp1** and the gate of the Pch MOS transistor **Tp2** are connected, and **B** denotes a node to which the drain of the Nch MOS transistor **Tn2,** the drain of the Pch MOS transistor **Tp2** and the gate of the Pch MOS transistor **Tp1** are connected.

The sources of the Nch MOS transistors **Tn1, Tn2** and the sources of the Pch MOS transistors **Tp1, Tp2** are respectively connected to the ground **VSSH** for the high-voltage power supply and the high-voltage power supply **VDDH.** The input signal terminal **IN** is for inputting a signal of a low power-supply voltage into the buffer **BUF1.** Signals in opposite phase to and in phase with the input signal **IN** from the two inverters **INV1, INV2** of the buffer **BUF1** are input into the gates of the Nch MOS transistors **Tn1, Tn2.** The input of the buffer **BUF2** on the output side is connected to the node B, and the output thereof is connected to the output signal terminal **OUT.**

The operation of the conventional level shift circuit configured as described above will be described.

When the input signal at the input signal terminal **IN** of the buffer **BUF1** has changed its level from low to high, signals in opposite phase to and in phase with the input signal are supplied from the inverters **INV1, INV2** of the buffer **BUF1** to the gates of the Nch MOS transistors **Tn2**, **Tn1,** respectively. At this time, the Nch MOS transistor **Tn2,** to the gate of which the signal in opposite phase to the input signal, that is, the signal changing from high to low is applied, gradually increases its ON resistance, and this increases the drain-source voltage of the Nch MOS transistor **Tn2**. Roughly simultaneously with this, the Nch MOS transistor **Tn1,** to the gate of which the signal in phase with the input signal is applied, goes ON and gradually reduces its ON resistance, and this reduces the drain-source voltage of the Nch MOS transistor **Tn1.**

With the operation of the two Nch MOS transistors **Tn1, Tn2** described above, the gate voltage of the Pch MOS transistor **Tp2** falls, and thus the drain voltage thereof rises. This in return increases the gate voltage of the Pch MOS transistor **Tp1.** Once the input signal input into the buffer **BUF1** finally reaches the high level, the drain-source of the Nch MOS transistor **Tn1** becomes completely conducting, and thus the voltage of the node A becomes 0V. Also, the drain-source of the Nch MOS transistor **Tn2** becomes completely non-conducting and the source-drain of the Pch MOS transistor **Tp2** becomes conducting. Thus, the voltage of the node **B** becomes equal to the high power supply voltage **VDDH.** At this time, with the shift of the voltage of the node **B** to the high power-supply voltage **VDDH,** the buffer **BUF2**, which operates at the high power-supply voltage **VDDH,** shifts the potential of the output signal to be output from the output signal terminal **OUT** to the high power-supply voltage **VDDH,** and supplies this output signal to a high power-supply voltage operating circuit not shown.

On the contrary, when the input signal at the input signal terminal **IN** changes its level from high to low, signals in opposite phase to and in phase with the input signal are supplied from the inverters **INV1, INV2** of the buffer **BUF1** to the gates of the Nch MOS transistors **Tn2, Tn1,** respectively. At this time, the Nch MOS transistor **Tn2,** to the gate of which the signal in opposite phase to the input signal, that is, the signal changing from low to high is applied, goes ON and gradually reduces its ON resistance, and this reduces its drain-source voltage. Roughly simultaneously with this, the Nch MOS transistor **Tn1,** to the gate of which the signal in phase with the input signal is applied, gradually increases its ON resistance, and this increases its drain-source voltage.

With the operation of the two Nch MOS transistors **Tn1, Tn2** described above, the gate voltage of the Pch MOS transistor **Tp1** falls and thus the drain voltage thereof rises. This in turn increases the gate voltage of the Pch MOS transistor Tp2. Once the input signal input into the buffer **BUF1** finally reaches the high level, the drain-source of the Nch MOS transistor **Tn2** becomes completely conducting, and thus the voltage of the node **B** becomes 0V. At this time, with the shift of the voltage of the node **B** to 0V, the buffer **BUF2,** which operates at the high power-supply voltage **VDDH,** shifts the potential of the output signal to be output from the output signal terminal **OUT** to 0V, and supplies this output signal to a high power-supply voltage operating circuit not shown. Also, the drain-source of the Nch MOS transistor **Tn1** becomes completely non-conducting and the source-drain of the Pch MOS transistor **Tp1** becomes conducting. Thus, the voltage of the node **A** becomes equal to the high power-supply voltage **VDDH.**

As described above, with the conventional level shift circuit, it became possible to level-shift a signal output from a low power-supply voltage operating circuit to a signal of the high power-supply voltage **VDDH** and output the level-shifted signal to a high power-supply voltage operating circuit.

However, the conventional configuration described above had the following problem. When the input signal at the input signal terminal **IN** changes its level from high to low, for example, it takes one step for the source-drain of the Nch MOS transistor **Tn2** to become conducting to thereby reduce the potential of the node **B.** From this state, it takes one more step for the source-drain of the Pch MOS transistor **Tp1** to become conducting to thereby change the potential of the node **A** from low to high. That is, two steps are necessary until the potential states of the respective terminals of the Nch MOS transistors **Tn1, Tn2** and the Pch MOS transistors **Tp1, Tp2** are changed and the output state, a high level or a low level, is determined. This makes high-speed operation difficult.

As a conventional level shift circuit intended to solve the above problem, a level shift circuit disclosed in Patent Literature 1 is shown in FIG. **6.** In the level shift circuit of FIG. **6,** additional Nch MOS transistors **Tn5, Tn4** are respectively connected in parallel with the two Pch MOS transistors **Tp1, Tp2** of the level shift circuit shown in FIG. 5, and the complementary input signals from the buffer **BUF1** are supplied to the gates of the Nch MOS transistors **Tn5, Tn4.**

In the level shift circuit of FIG. 6 with the configuration described above, when the complementary input signals from the buffer **BUF1** operating at low power-supply voltage are reversed, one (for example, **Tn1)** of the pair of Nch MOS transistors **Tn1, Tn2** is turned ON, changing the node **A** to a low level. Simultaneously, one (for example, Tn5) of the two additional Nch MOS transistors **Tn5, Tn4** is turned ON, changing the node **B** to the high power-supply voltage **VDDH.** In this way, only one step is necessary to raise the output state to a high level.
Patent Literature 1: Japanese Laid-Open Patent Publication No. 5-332593

### DISCLOSURE OF THE INVENTION

### Problems to be solved by the Invention

However, the conventional level shift circuit shown in FIG. 6 has a problem that the area increases with the addition of the two Nch MOS transistors **Tn5, Tn4.** Moreover, with the drains of the Nch MOS transistors **Tn5, Tn4** directly connected to the high-voltage power supply **VDDH,** a reverse bias of the high power-supply voltage VDDH will be applied to the back gates and drains of the Nch MOS transistors **Tn5, Tn4,** depending on the fabrication process of semiconductor elements. This may degrade the reliability of the elements.

Furthermore, in the conventional level shift circuit, the two Nch MOS transistors **Tn5,** Tn4 added for high-speed implementation must be operated regardless of the frequency of the input signal **IN.** Therefore, if the input signal **IN** is low in frequency requiring no high-speed level shift operation, power consumption will wastefully increase by the redundant operation of the Nch MOS transistors **Tn5, Tn4.**

In view of the technical problems described above, the first object of the present invention is achieving speedup of the operation of a level shift circuit with a smaller number of elements than in the conventional one while securing high level of reliability of the elements.

The second object of the present invention is achieving low power consumption by stopping the operation of added elements when low-speed level shift operation is enough.

### MEANS FOR SOLVING THE PROBLEMS

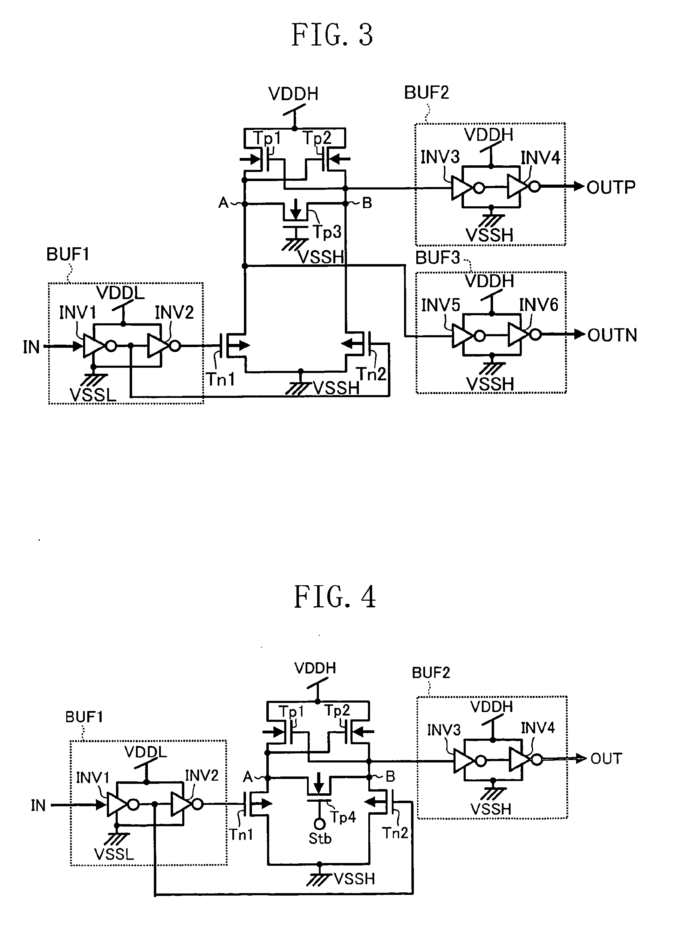

To attain the first object described above, the present invention adopts a configuration that two nodes **A** and **B** are connected with each other via a resistance in the conventional level shift circuit shown in FIG. **4.**

To attain the second object described above, the present invention adopts a configuration that the above additional resistance is composed of one normally ON transistor and this transistor is turned OFF as required.

Specifically, the level shift circuit of the present invention includes: first and second P-channel transistors of which sources are connected to a high-voltage power supply; and first and second N-channel transistors of which sources are grounded, wherein complementary input signals in phase with and in opposite phase to an input signal from a low power-supply voltage operating circuit are respectively inputted to gates of the first and second N-channel transistors, a drain of the first N-channel transistor is connected to a drain of the first P-channel transistor and a gate of the second P-channel transistor, a drain of the second N-channel transistor is connected to a drain of the second P-channel transistor and a gate of the first P-channel transistor, the level shift circuit further comprises a resistance connecting the drain of the first N-channel transistor with the drain of the second N-channel transistor, and the drain of the second N-channel transistor serves as an output terminal to a high power-supply voltage operating circuit.

In the level shift circuit described above, the resistance is constructed of a P-channel transistor, and the P-channel transistor is grounded at its gate, connected to the drain of the first N-channel transistor at its source, and connected to the drain of the second N-channel transistor at its drain, to be in the normally ON state.

In the level shift circuit described above, the resistance is constructed of an N-channel transistor, and the N-channel transistor is connected to a high-voltage power supply at its gate, connected to the drain of the first N-channel transistor at its source, and connected to the drain of the second N-channel transistor at its drain, to be in the normally ON state.

In the level shift circuit described above, the resistance is constructed of a P-channel transistor, and the P-channel transistor receives an ON/OFF operation switch signal at its gate, connected to the drain of the first N-channel transistor at its source, and connected to the drain of the second N-channel transistor at its drain.

In the level shift circuit described above, the resistance is constructed of an N-channel transistor, and the N-channel transistor receives an ON/OFF operation switch signal at its gate, connected to the drain of the first N-channel transistor at its source, and connected to the drain of the second N-channel transistor at its drain.

In the level shift circuit described above, the ON/OFF operation switch signal is an operation mode switch signal received from outside.

In the level shift circuit described above, the drains of the first and second N-channel transistors serve as differential output terminals for the high power-supply voltage operating circuit.

The semiconductor integrated circuit of the present invention includes the level shift circuit described above.

As described above, according to the present invention, in the case of input of a high-speed signal, when the input signal is reversed, a current is supplied from a node on the high potential side, out of nodes A, B on the low and high potential sides, to the node on the low potential side that is to shift to the high potential side through a resistance. This permits the node on the low potential side to raise its potential swiftly to become high potential. Accordingly, the shift of the node on the low potential side to high potential can be sped up. Also, since the resistance provided additionally is a one-element resistance made up of one transistor, the number of elements can be reduced by one compared with the conventional example shown in FIG. 5. Moreover, with one transistor as the resistance, no reverse bias of the high power-supply voltage will be applied between its back gate and drain, and thus the reliability is highly secured.

In particular, according to the present invention, when a low-speed input signal is input, one transistor constituting the resistance is turned OFF (non-conducting) to stop high-speed operation. This can save redundant power consumption with the additional transistor (resistance)

### EFFECT OF THE INVENTION

As described above, in the level shift circuit and the semiconductor integrated circuit of the present invention, a current is supplied from a node on the high potential side to a node on the low potential side that is to shift to the high potential side through a resistance, to thereby enable speedup of the level shift circuit, while the resistance is made up of one element and the element is prevented from being exposed to a high power-supply voltage, to thereby highly secure its reliability.

In particular, according to the level shift circuit of the present invention, when a low-speed input signal is input, the additional transistor (resistance) is turned OFF to thereby enable saving of redundant power consumption of the transistor.

### BRIEF DESCRIPTION OF THE DRAWINGS

[FIG. 1] FIG. **1** is a view showing a level shift circuit of Embodiment 1 of the present invention.
[FIG. 2] FIG. **2** is a view showing a level shift circuit of Embodiment 2 of the present invention.
[FIG. 3] FIG. **3** is a view showing a level shift circuit of Embodiment 3 of the present invention.
[FIG. 4] FIG. **4** is a view showing a level shift circuit of Embodiment 4 of the present invention.
[FIG. 5] FIG. **5** is a view showing a conventional level shift circuit.
[FIG. 6] FIG. **6** is a view showing a conventional level shift circuit improved from the level shift circuit of FIG. 5.

### Description of reference numerals

- Tp1: First Pch MOS transistor
- Tp2: Second Pch MOS transistor
- Tn1: First Nch MOS transistor
- Tn2: Second Nch MOS transistor
- Tp3, Tp4: Pch MOS transistors (resistances)
- Tn3: Nch MOS transistor (resistance)
- Tn4: Nch MOS transistor
- Tn5: Nch MOS transistor
- BUF1, BUF2, BUF3: Buffers
- A, B: Nodes
- IN: Input terminal
- OUT: Output terminal
- OUTP, OUTN: Differential output terminals
- VDDH: High power-supply voltage
- VDDL: Low power-supply voltage
- VSSH: Ground for high power-supply voltage
- VSSL: Ground for low power-supply voltage
- Stb: Standby mode signal
(ON/OFF switch signal and operation mode switch signal)

### BEST MODE FOR CARRYING OUT THE INVENTION

Hereinafter, level shift circuits of embodiments of the present invention will be described in detail with reference to the drawings.

### (Embodiment 1)

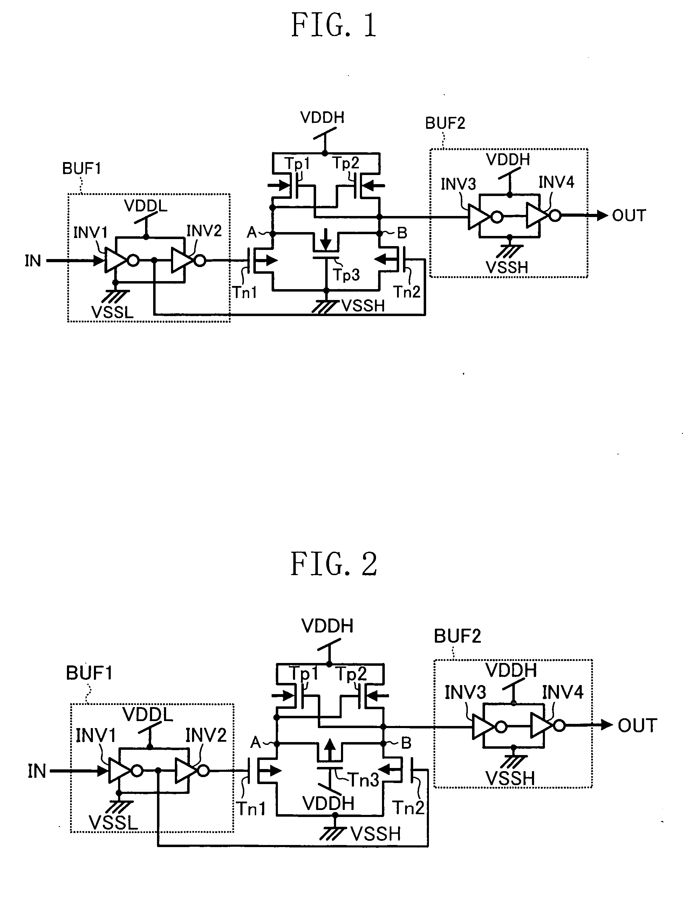

FIG. 1 shows a configuration of a level shift circuit of Embodiment 1 of the present invention.

Referring to FIG. **1, BUF1** denotes a buffer on the input side including inverters **INV1, INV2** operating at a low power-supply voltage **VDDL** and a ground (0V) **VSSL** for this voltage, and BUF2 denotes a buffer on the output side including inverters **INV3, INV4** operating at a high power-supply voltage **VDDH.** The buffers **BUF1** and BUF2 should just have a buffer function, and are not necessarily a circuit having multi-stage connection of inverters.

Also referring to FIG. **1, Tn1, Tn2** denote first and second Nch MOS transistors of which sources are connected to the ground (0V) **VSSH** for the high-voltage power supply **VDDH. Tp1, Tp2** denote first and second Pch MOS transistors of which sources are connected to the high-voltage power supply **VDDH. IN** denotes an input terminal for an input signal of a low power-supply voltage to be input into the buffer **BUF1** on the input side (hereinafter, the input signal itself is also referred to as **IN).** The input signal **IN** is supplied from a low power-supply voltage operating circuit not shown.

The output of the first-stage inverter **INV1** of the buffer **BUF1** on the input side, that is, a signal in opposite phase to the input signal **IN** is input into the gate of the second Nch MOS transistor Tn2, while the output of the second-stage inverter **INV2,** that is, a signal in phase with the input signal **IN** is input into the gate of the first Nch MOS transistor **Tn1.**

The drain of the Nch MOS transistor **Tn1** is connected to the drain of the Pch MOS transistor **Tp1,** and the connection point thereof is referred to as node **A.** The node **A** is connected to the gate of the Pch MOS transistor **Tp2.** Likewise, the drain of the Nch MOS transistor **Tn2** is connected to the drain of the Pch MOS transistor **Tp2,** and the connection point thereof is referred to as node **B.** The node **B** is connected to the gate of the Pch MOS transistor **Tp1.**

The first-stage inverter **INV3** of the buffer **BUF2** is connected to the node **B,** and an output signal of the high power-supply voltage **VDDH** from the second-stage inverter **INV4** is output externally from the output terminal **OUT** (hereinafter, the output signal is also referred to as **OUT).**

The two nodes **A** and **B** are connected with each other via a Pch MOS transistor **Tp3** as a resistance. Specifically, the Pch MOS transistor (resistance) **Tp3** is connected to the node **A** at its source and to the node **B** at its drain, and the ground **VSSH** for the high-voltage power supply is connected to its gate, to allow for normally ON operation.

Hereinafter, the operation of the level shift circuit will be described.

When the input signal at the input signal terminal **IN** changes its level from low to high, signals in opposite phase to and in phase with the input signal are supplied from the two inverters **INV1, INV2** of the buffer **BUF1,** which is a low power-supply voltage operation circuit, to the gates of the Nch MOS transistors **Tn2, Tn1.** At this time, the Nch MOS transistor **Tn2**, to the gate of which the signal in opposite phase to the input signal IN, that is, a signal changing from high to low is applied, gradually increases its ON resistance. This increases the drain-source voltage of the Nch MOS transistor **Tn2,** and thus the level of the node **B** starts to rise. Roughly simultaneously with this, the Nch MOS transistor **Tn1,** to the gate of which the signal in phase with the input signal **IN** is applied, starts going ON, allowing a current to start flowing from the node **A** to the ground **VSSH** through the Nch MOS transistor **Tn1,** and thus ON resistance of the Nch MOS transistor **Tn1** gradually decreases. This reduces the drain-source voltage of the Nch MOS transistor **Tn1,** and thus lowers the level of the node **A.**

With the shift of the node **A** to the low level, the gate voltage of the Pch MOS transistor Tp2 decreases, causing start of ON operation, and thus the drain voltage of the Pch MOS transistor Tp2, that is, the level of the node **B** rises. The node **B** shifting to the high-level side was in the low level before the change of the input signal **IN,** and the node **A** shifting to the low-level side was in the high level before the change of the input signal **IN.** Therefore, simultaneously with, or from the stage prior to, the start of the ON operation of the Pch MOS transistor Tp2, a current flows from the node **A** on the high-level side to the node **B** on the low-level side through the resistance (Pch MOS transistor) **Tp3,** and this speeds up the potential rise at the node **B** shifting to the high-level side.

Thanks to the speedup of the potential rise at the node **B** shifting to the high-level side, the time taken for the potential at the node **B** to exceed the threshold voltage of the first-stage inverter **INV3** of the buffer **BUF2** on the output side operating at a high power-supply voltage is shortened, allowing the output from the output terminal **OUT** of the buffer **BUF2** to reach the high power-supply voltage **VDDH** early. With the potential rise at the node **B,** also, the gate voltage of the Pch MOS transistor **Tp1** rises. The Pch MOS transistor **Tp1** therefore starts OFF operation, making it difficult to supply the high power-supply voltage **VDDH,** and thus the level fall of the node **A** continues. Although the node **B** shifting to the high-level side is on the grounding route from the high-voltage power supply **VDDH** through the Pch MOS transistor Tp2, the resistance (Pch MOS transistor) **Tp3** and the Nch MOS transistor **Tn1** down to the ground, it is located upstream of the resistance (Pch MOS transistor) Tp3. Therefore, by appropriately setting the resistance value of the resistance Tp3, the potential level of the node **B** that has shifted to the high-level side is prevented from decreasing to below the threshold voltage of the first-stage inverter **INV3** of the buffer **BUF2** on the output side after it has once exceeded the threshold voltage.

Contrary to the above, when the level of the input signal at the input signal terminal **IN** changes its level from high to low, operation reverse to the operation described above is performed. Specifically, the Nch MOS transistor **Tn2,** to the gate of which a signal in opposite phase to the input signal **IN,** that is, a signal changing from low to high is applied, starts going ON, allowing a current to start flowing from the node **B** to the ground **VSSH** through the Nch MOS transistor **Tn2,** and thus ON resistance of the Nch MOS transistor **Tn2** gradually decreases. This reduces the drain-source voltage of the Nch MOS transistor **Tn2** and thus lowers the level of the node **B.** Roughly simultaneously with this, the Nch MOS transistor **Tn1,** to the gate of which a signal in phase with the input signal **IN** is applied, gradually increases its ON resistance. This increases the drain-source voltage of the Nch MOS transistor **Tn1,** and the level of the node **A** starts to rise.

With the shift of the node **B** to the low level, the gate voltage of the Pch MOS transistor **Tp1** falls, causing start of ON operation, and thus the drain voltage of the Pch MOS transistor **Tp1,** that is, the level of the node **A** rises. The node **A** shifting to the high-level side was in the low level before the change of the input signal **IN,** and the node **B** shifting to the low-level side was in the high level before the change of the input signal **IN.** Therefore, simultaneously with, or from the stage prior to, the start of the ON operation of the Pch MOS transistor **Tp1,** a current flows from the node **B** on the high-level side to the node **A** on the low-level side through the resistance (Pch MOS transistor) **Tp3,** and this speeds up the potential rise at the node **A** shifting to the high-level side.

Thanks to the speedup of the potential rise at the node **A** shifting to the high-level side, the gate voltage of the Pch MOS transistor Tp2 rises swiftly, allowing the Pch MOS transistor Tp2 to start going OFF early. Therefore, the supply of the high power-supply voltage **VDDH** becomes difficult, and this speeds up the level fall of the node **B.** This results in shortening the time taken for the level of the node **B** to become below the threshold voltage of the first-stage inverter INV3 of the buffer BUF2 operating at a high power-supply voltage, allowing the output signal from the output terminal **OUT** of the buffer BUF2 to become the ground voltage **VDDL** early.

In the level shift circuit of this embodiment shown in FIG. **1,** the potential at the node **A** or **B** on the high-level side is a potential determined by the resistance division among the three serially-connected transistors **(Tp1, Tp3** and **Tn2)** or **(Tp2, Tp3** and **Tn1)** that are in the ON state, and will not be the high power-supply voltage **VDDH.** Therefore, in the transistor Tp3 additionally supplied, the conventional trouble that a reverse bias of the high power-supply voltage **VDDH** is applied to its back gate and drain can be avoided, and thus reliability is well secured.

### (Embodiment 2)

A level shift circuit of Embodiment 2 of the present invention will be described.

FIG. **2** shows a configuration of the level shift circuit of Embodiment 2. The level shift circuit shown in FIG. **2** is different from the level shift circuit of FIG. **1** in that the transistor constituting the resistance was the Pch MOS transistor Tp3 in FIG. **1** but is a Nch MOS transistor Tn3 in this embodiment. Specifically, the Nch MOS transistor (resistance) Tn3 is connected to the node **A** at its source and to the node **B** at its drain, and the gate thereof is connected to the high-voltage power supply **VDDH,** to allow for normally ON operation.

Therefore, in this embodiment, also, the same function and effect as those in Embodiment 1 can be obtained.

### (Embodiment 3)

A level shift circuit of Embodiment 3 of the present invention will be described.

FIG. **3** shows a configuration of the level shift circuit of Embodiment 3. The level shift circuit shown in FIG. **3,** of which output signal is a differential signal, is different from the level shift circuit of FIG. **1** in that a buffer **BUF3** is additionally provided on the output side.

The buffer **BUF3** on the output side includes two inverters **INV5, INV6** operating at the high power-supply voltage **VDDH** and the corresponding ground **VSSH.** The first-stage inverter **INV5** is connected to the node **A.** The outputs of the two buffers **BUF2** and **BUF3** on the output side are connected to an output terminal **OUTP** outputting a signal in phase with the input signal **IN** and an output terminal **OUTN** outputting a signal in opposite phase to the input signal **IN,** respectively. The output terminals **OUTP** and **OUTN** constitute a pair of differential output terminals.

In this embodiment, although the placement of the pair of differential output terminals **OUTP** and **OUTN** was applied to the level shift circuit of FIG. **1,** this placement is also applicable to the level shift circuit of FIG. **2.**

### (Embodiment 4)

FIG. **4** shows a level shift circuit of Embodiment 4 of the present invention.

The level shift circuit shown in FIG. **4** is the same in configuration as the level shift circuit shown in FIG. **1,** except that a Pch MOS transistor Tp4 for connecting the two nodes **A** and **B** receives a standby mode signal **Stb** at its gate as an ON/OFF operation switch signal. In the normal operation mode in which a high-frequency high-speed signal is input via the input terminal **IN,** the standby mode signal (operation mode switch signal) **Stb** falls to the low level **VSSH,** to put the Pch MOS transistor (resistance) **Tp4** additionally provided in the normally ON state. In the standby mode in which a low-frequency low-speed signal is input via the input terminal **IN,** the standby mode signal Stb rises to the high level **VDDH,** to put the Pch MOS mode transistor (resistance) **Tp4** in the normally OFF state. The standby mode signal **Stb** is supplied from an LSI (semiconductor integrated circuit) including the level shift circuit of this embodiment.

In this embodiment, therefore, in the standby mode, in which a low-frequency low-speed signal is input via the input terminal **IN,** no high-speed level shift operation is necessary for the level shift circuit, but normal speed is enough. In this situation, the standby mode signal **Stb** of the high level **VDDH** is input, to put the Pch MOS transistor (resistance) Tp4 in the normally OFF state. In this state, the operation of speeding up the potential rise at the node shifting to the high level with supply of a current from the node on the high level side is stopped. Therefore, the level shift circuit performs normal-speed level shift operation. In this way, in the standby mode, redundant operation as conventionally done is not involved, and thus lower power consumption than in the conventional case can be achieved.

In this embodiment, the standby mode signal **Stb** was input into the Pch MOS transistor (resistance) **Tp4.** Alternatively, a sleep mode signal and the like may be used. The level shift circuit of FIG. **1** was modified to obtain the level shift circuit of this embodiment. Naturally, the level shift circuits of FIG. **2** and FIG. **3** may be modified to obtain the level shift circuit of this embodiment. In the case using the Nch MOS transistor (resistance) Tn3, the standby mode signal **Stb** of the low level **VSSL** may be input in the standby mode.

The level shift circuits of the present invention were described with reference to FIGS. **1** to **4.** The present invention also includes a semiconductor integrated circuit having any of such level shift circuits, a low power-supply voltage operating circuit and a high power-supply voltage operating circuit, in which an output signal from the low power-supply voltage operating circuit is level-shifted to a high power-supply voltage **VDDH** and the voltage **VDDH** is output to the high power-supply voltage operating circuit.

### INDUSTRIAL APPLICABILITY

According to the present invention, with only addition of one resistance, high-speed level shift operation can be attained while the reliability of the resistance is well secured. Therefore, the present invention is useful as a small-size level shift circuit for level-shifting a low-voltage signal to a high-voltage signal at high speed in propagation of a signal between a plurality of circuit sections having different power-supply voltages, and a semiconductor integrated circuit including such a level shift circuit and the plurality of circuit sections.

## Claims

1. A level shift circuit comprising:
first and second P-channel transistors of which sources are connected to a high-voltage power supply; and
first and second N-channel transistors of which sources are grounded,
wherein complementary input signals in phase with and in opposite phase to an input signal from a low power-supply voltage operating circuit are respectively inputted to gates of the first and second N-channel transistors,
a drain of the first N-channel transistor is connected to a drain of the first P-channel transistor and a gate of the second P-channel transistor,
a drain of the second N-channel transistor is connected to a drain of the second P-channel transistor and a gate of the first P-channel transistor,
the level shift circuit further comprises a resistance connecting the drain of the first N-channel transistor with the drain of the second N-channel transistor, and
the drain of the second N-channel transistor serves as an output terminal to a high power-supply voltage operating circuit.

2. The level shift circuit of Claim 1,
wherein the resistance is constructed of a P-channel transistor, and
the P-channel transistor is grounded at its gate, connected to the drain of the first N-channel transistor at its source, and connected to the drain of the second N-channel transistor at its drain, to be in the normally ON state.

3. The level shift circuit of Claim 1,
wherein the resistance is constructed of an N-channel transistor, and
the N-channel transistor is connected to a high-voltage power supply at its gate, connected to the drain of the first N-channel transistor at its source, and connected to the drain of the second N-channel transistor at its drain, to be in the normally ON state.

4. The level shift circuit of Claim 1,
wherein the resistance is constructed of a P-channel transistor, and
the P-channel transistor receives an ON/OFF operation switch signal at its gate, connected to the drain of the first N-channel transistor at its source, and connected to the drain of the second N-channel transistor at its drain.

5. The level shift circuit of Claim 1,
wherein the resistance is constructed of an N-channel transistor, and
the N-channel transistor receives an ON/OFF operation switch signal at its gate, connected to the drain of the first N-channel transistor at its source, and connected to the drain of the second N-channel transistor at its drain.

6. The level shift circuit of Claim 4 or 5,
wherein the ON/OFF operation switch signal is an operation mode switch signal received from outside.

7. The level shift circuit of any one of Claims 1 to 6,
wherein the drains of the first and second N-channel transistors serve as differential output terminals for the high power-supply voltage operating circuit.

8. A semiconductor integrated circuit comprising the level shift circuit of any one of Claims 1 to 7.
